# EUROPÄISCHE PATENTSCHRIFT

(11) **EP 3 023 832 B1**
(45) Veröffentlichungstag und Bekanntmachung des Hinweises auf die Patenterteilung: **28.03.2018**
(21) Anmeldenummer: 14194531.1
(22) Anmeldetag: 24.11.2014
(51) Int. Cl.: H01S 3/11, H03K 3/00, H03K 5/02, H03K 5/04, G02F 1/03, H01S 3/107

(54) **Pockelszellen-Treiberschaltung mit Induktivitäten**
Pockels cell driver circuit with inductivities
Circuit d'excitation à cellules de Pockels ayant des inductivités

(43) Veröffentlichungstag der Anmeldung: 25.05.2016
(73) Patentinhaber: Bergmann Messgeräte Entwicklung KG, 82418 Murnau (DE); Helmholtz-Zentrum Dresden - Rossendorf e.V., 01328 Dresden (DE)
(72) Erfinder: Dr. Bergmann, Thorald, 82418 Murnau (DE); Dr. Siebold, Mathias, 01328 Dresden (DE); Löser, Markus, 01328 Dresden (DE)
(74) Vertreter: Patentanwälte Lambsdorff & Lange

(56) Entgegenhaltungen:
- WO-A1-2014/027227
- US-A- 3 879 687
- US-A- 5 189 547
- US-A1- 2008 018 977

## Beschreibung

Die vorliegende Erfindung betrifft eine Treiberschaltung für eine Pockelszelle, eine Pockelszelle mit einer derartigen Treiberschaltung und ein Lasersystem mit einer Pokkelszelle und einer derartigen Treiberschaltung.

In Lasersystemen können elektro-optische Modulatoren wie Pockelszellen eingesetzt werden, um Laserpulse zu schalten oder zu selektieren. Eine Pockelszelle kann durch eine geeignete schaltbare Hochspannungsversorgung zwischen zwei Zuständen hin und her geschaltet werden. Die Spannung, welche erforderlich ist, um die jeweils zwei genannten Zustände zu erreichen, ist eine Funktion der Kristallparameter und der verwendeten Wellenlänge des zu schaltenden Lichts. In vielen Anwendungsfällen kommt es darauf an, möglichst schnelle Schaltzeiten zu erzielen. Es gibt aber auch Situationen, in denen es vorteilhaft ist, wenn zumindest eine der beiden Schaltzeiten langsamer ist, als es durch das Schaltelement, also im Regelfall den Transistor, selbst möglich wäre. Eine Pockelszelle kann beispielsweise innerhalb eines Laserresonators als ein Cavity Dumper eingesetzt werden. Hierbei kann es wünschenswert sein, den durch den Cavity Dumper aus dem Resonator ausgekoppelten Puls länger zu machen und seine Spitzenintensität zu verringern. Dies kann durch Verlängern der Schaltzeiten der Treiberschaltung der Pockelszelle erreicht werden. Ebenso kann es wünschenswert sein, einen ursprünglich rechteckigen Laserpuls, der nach Durchgang durch eine Verstärkerschaltung in seiner Amplitude verzerrt worden ist, durch geeignete Variation der angelegten Spannung an die Pokkelszelle zu korrigieren, um wieder die ursprünglich rechtekkige Form zu erzielen. Demgemäß werden Treiberschaltungen bebenötigt, bei welchen wenigstens eine der Schaltflanken oder ein Teil dieser Schaltflanke langsamer gemacht wird als es normale Schaltelemente zulassen würden oder in ihrer Amplitude im Vergleich mit normalen Schaltelementen in bestimmter Weise beeinflußt wird.

Die Druckschrift WO 2014/027227 A1 offenbart eine Treiberschaltung für eine innerhalb einer Laserstrahlquelle angeordnete Pockelszelle, welche eine Spule und eine durch die Pockelszelle selbst bereitgestellte Kapazität enthält. Durch den solchermaßen bereitgestellten LC-Schaltkreis können Spannungsoszillatzonen erzeugt werden, welche bei geeigneter Dimensionierung der Induktivität mit einer derartigen Frequenz erzeugt werden können, welche ein aktives Mode-Locking der Laserstrahlquelle ermöglicht.

Die Druckschrift US 5,189,547 A offenbart in den Figuren 3 und 5 ebenfalls eine Treiberschaltung für eine Pockelszelle mit einer Induktivität in einer mit einem Anschluß der Pockelszelle zu verbindenden Leitung, um mittels dieser und weiteren Schaltungskomponenten einen zwischen einer Signalquelle und der Pockelszelle geschalteten passiven resonanten Schwingkreis bereitzustellen.

Es ist somit Aufgabe der vorliegenden Erfindung, eine Treiberschaltung für eine Pockelszelle anzugeben, mit welcher der zeitliche Verlauf einer an die Pockelszelle angelegten Spannung gezielt beeinflußt werden kann. Insbesondere ist es Aufgabe der vorliegenden Erfindung, eine Treiberschaltung für eine Pockelszelle anzugeben, mit welcher mindestens eine Schaltflanke verzögert werden kann oder ein Teil dieser Schaltflanke verzögert oder in ihrer Amplitude beeinflußt wird und/oder falls erforderlich, die Spannung zwischen den beiden Schaltflanken in gewünschter Weise variiert werden kann.

Diese Aufgabe wird mit den Merkmalen des Patentanspruchs 1 gelöst. Vorteilhafte Weiterbildungen und Ausgestaltungen sind Gegenstand von Unteransprüchen oder nebengeordneten Ansprüchen.

Die beigefügten Zeichnungen sind vorgesehen, um ein weiteres Verständnis von Ausführungsformen zu gewährleisten und sind in die vorliegende Beschreibung integriert und bilden einen Teil dieser. Die Zeichnungen zeigen Ausführungsformen und dienen zusammen mit der Beschreibung zur Erläuterung von Prinzipien von Ausführungsformen.
Fig. 1 zeigt eine schematische Darstellung einer Treiberschaltung in Form einer Push-Pull-Schaltung gemäß einer Ausführungsform ohne parallel geschaltete Kondensatoren bzw. Dioden.
Fig. 2 zeigt eine schematische Darstellung einer Treiberschaltung in Form einer Push-Pull-Schaltung gemäß einer Ausführungsform mit Kondensatoren und/oder Dioden.
Fig. 3 zeigt eine schematische Darstellung einer Treiberschaltung in Form einer Brückenschaltung im dpp-Modus gemäß einer Ausführungsform ohne Kondensatoren bzw. Dioden.
Fig. 4 zeigt eine schematische Darstellung einer Treiberschaltung in Form einer Brückenschaltung im dpp-Modus gemäß einer Ausführungsform mit Kondensatoren und/oder Dioden.
Fig. 5 zeigt eine schematische Darstellung einer Treiberschaltung in Form einer Brückenschaltung in einer ersten Ausführungsform eines bpp-Modus ohne Kondensatoren bzw. Dioden.
Fig. 6 zeigt eine schematische Darstellung einer Treiberschaltung in Form einer Brückenschaltung in der ersten Ausführungsform des bpp-Modus mit Kondensatoren und/oder Dioden.
Fig. 7 zeigt eine schematische Darstellung einer Treiberschaltung in Form einer Brückenschaltung in einer zweiten Ausführungsform eines bpp-Modus ohne Kondensatoren bzw. Dioden.
Fig. 8 zeigt eine schematische Darstellung einer Treiberschaltung in Form einer Brückenschaltung in der zweiten Ausführungsform eines bpp-Modus mit Kondensatoren und/oder Dioden.
Fig. 9 zeigt eine schematische Darstellung einer 3-stufigen Verstärkerkette, bei welcher eine Pockelszelle mit einer in dieser Anmeldung offenbarten Treiberschaltung angesteuert wird.
Fig. 10 zeigt eine schematische Darstellung einer Ausführungsform einer Laserstrahlquelle mit einer resonatorinternen Pockelszelle als Cavity Dumper, welche mit einer in dieser Anmeldung offenbarten Treiberschaltung angesteuert wird.

Insofern in der folgenden Beschreibung, den Patentansprüchen oder den Zeichnungen zum Ausdruck gebracht wird, dass Schaltungselemente miteinander "verbunden", "elektrisch verbunden" oder "elektrisch gekoppelt" sind, so kann dies bedeuten, dass die genannten Elemente direkt, d.h. ohne dazwischen befindliche weitere Elemente miteinander gekoppelt sind. Es kann jedoch auch bedeuten, dass die genannten Elemente nicht direkt miteinander gekoppelt sind und dass weitere Elemente zwischen die genannten Elemente gekoppelt sind. Insofern in den Figuren gleiche Bezugszeichen verwendet werden, so beziehen sich diese auf gleiche oder funktionsgleiche Elemente, so dass in diesen Fällen die Beschreibung dieser Elemente nicht wiederholt wird. Im Rahmen dieser Anmeldung wird der Begriff "Induktivität" auch synonym mit dem Begriff "Induktivitäts-Bauelement" verwendet, der Begriff "Widerstand" wird auch synonym mit dem Begriff "Widerstands-Bauelement" verwendet, und der Begriff "Kondensator" wird auch synonym mit dem Begriff "Kondensator-Bauelement verwendet.

Eine beispielhafte Treiberschaltung für eine Pockelszelle enthält eine erste Leitung, welche mit einem ersten Anschluß der Pockelszelle zu verbinden ist, und eine zweite Leitung, welche mit einem zweiten Anschluß der Pockelszelle zu verbinden ist, wobei die erste Leitung und/oder die zweite Leitung eine Induktivität aufweist, insbesondere in die erste Leitung und/oder die zweite Leitung eine Induktivität bzw. ein Induktivitäts-Bauelement eingebunden ist.

In Lasersystemen hat man häufig das Problem, dass ein beispielsweise rechteckförmiger Laserpuls, dessen Strahlungsleistung oder -intensität zum Zeitpunkt t0 von Amplitude Null auf eine bestimmte Amplitude A innerhalb kurzer Zeit, z.B. einige nsec oder psec, ansteigt, diese Amplitude A für eine längere Zeit, z.B. einige wenige nsec bis einige hundert nsec, konstant hält, und dann wiederum zum Zeitpunkt t1 innerhalb kurzer Zeit, z.B. einige nsec oder psec, wieder auf Null abfällt, beim Durchtritt durch ein Verstärkungsmedium aufgrund der Abnahme der Verstärkung (Gain Depletion) eine unerwünschte Verformung erfährt, die im Wesentlichen daraus besteht, dass die Ausgangsstrahlungsleistung B, welche über längere Zeit konstant gehalten werden sollte, zwischen den Zeitpunkten t0 und t1 langsam abfällt. Diese Abnahme kann einige Prozent betragen, die Strahlungsleistung kann aber auch zum Zeitpunkt t1 nur noch einen kleinen Bruchteil der Strahlungsleistung zum Zeitpunkt t0 betragen. Eine mögliche Lösung dieses Problems könnte darin bestehen, den Laserpuls vor Eintritt in das Verstärkungsmedium geeignet zu verformen, nämlich zum Zeitpunkt t0 einen schnellen Anstieg innerhalb kurzer Zeit, z.B. einige nsec oder psec, von Strahlungsleistung Null auf eine bestimmte erste kleinere Strahlungsleistung A1 zu erzeugen, wobei diese Strahlungsleistung A1 dann nicht konstant ist, sondern innerhalb der Pulsdauer, einige wenige nsec bis einige hundert nsec von t0 bis t1, auf eine größere Strahlungsleistung A2 ansteigt, und dann wiederum zum Zeitpunkt t1 innerhalb kurzer Zeit, z.B. einige nsec oder psec, wieder auf Null abfällt. Mit einem derartig verformten Puls am Eintritt des Verstärkungsmediums kann man einen verstärkten Laserpuls mit im Wesentlichen rechteckförmigem oder zeitsymmetrischem Profil erhalten. Die in dieser Anmeldung vorgestellte Treiberschaltung eignet sich insbesondere für diese Anwendung, wobei sich vorteilhaft für die Kompensation der Verstärkungsabnahme auswirkt, dass die verformte Anstiegsflanke eine positive Krümmung der Intensitäts-Zeit bzw. Spannungs-Zeit-Funktion aufweist. Generell ermöglicht es die in dieser Anmeldung vorgestellte Treiberschaltung, eine lange oder kurze Anstiegsflanke derart zu formen, dass sie eine lange, insbesondere exponentiell ansteigende Anstiegsflanke von bis zu einigen 100 ns Länge aufweist, wobei die Länge u.a. von der Wahl des Induktivitätswerts der mindestens einen Induktivität abhängen kann.

Gemäß einer Ausführungsform der Treiberschaltung weist diese in einer oder beiden der ersten Leitung und der zweiten Leitung einen zu der Induktivität (L1, L2) parallel geschalteten Kondensator und/oder eine zu der Induktivität (L1, L2) parallel geschaltete Diode auf. Bei dem Kondensator und der Diode handelt es sich insbesondere um einen Hochspannungskondensator bzw. eine Hochspannungsdiode, also um Bauelemente, welche für den Betrieb bei Spannungen im kV-Bereich ausgelegt sind.

Gemäß einer Ausführungsform der Treiberschaltung ist diese ferner derart ausgestaltet, dass durch die Treiberschaltung ein Spannungspuls erzeugbar ist, welcher eine Anstiegsflanke im Nanosekunden oder Subnanosekunden-Bereich (geradliniger/ungekrümmter als auch gekrümmter/exponentieller Anstieg möglich), einen sich daran anschließenden exponentiell ansteigenden Abschnitt, und eine sich daran anschließende abfallende Flanke im Nanosekunden-Bereich aufweist, wobei mit "Nanosekunden- oder Subnanosekunden-Bereich" ein Bereich von 0.1 ns - 10 ns gemeint sein kann und der exponentiell ansteigende Abschnitt eine Zeitdauer im Bereich 1 ns bis einige (bspw. Faktor 5-10) 100 ns aufweisen kann. Um dies zu erreichen kann beispielsweise eine oder beide der ersten Leitung und der zweiten Leitung einen zu der Induktivität parallel geschalteten Kondensator und/oder Diode aufweisen. Der Kapazitätswert des oder der Kondensatoren kann dabei in einem Bereich unterhalb der Kapazitätswerte kommerziell erhältlicher Hochspannungs-Kondensatoren, insbesondere unterhalb von ≤ 0,1 nF bzw. unterhalb von 10 pF liegen. Zum Zeitpunkt t0 des Anschaltens der Spannung durch die Treiberschaltung kann die intrinsische Kapazität der in Sperr-Richtung gepolten Diode genutzt werden, um zumindest einen Teil des Spannungssprungs bei t0 zu erreichen. Ist die intrinsische Kapazität der Diode zu klein, muss ein normaler Hochspannungskondensator zusätzlich parallel geschaltet werden. Zum Zeitpunkt t1 des Abschaltens der Spannung durch die Treiberschaltung dient die dann in Durchlassrichtung gepolte Diode dem schnellen Entladen der Pockelszelle CP.

Ebenso ist es möglich, die Diode so zu polen, dass zum Zeitpunkt t0 des Anschaltens der Spannung die Diode in Durchlassrichtung gepolt ist und der volle Spannungssprung auf die Pockelszelle CP übertragen wird, und dass zum Zeitpunkt t1 des Ausschaltens der Spannung die Diode in Sperr-Richtung gepolt ist, wodurch zunächst nur ein Teil des Spannungssprungs auf die Pockelszelle CP übertragen wird, und dann die Pokkelszelle langsam entladen wird, womit man bei einem Cavity Dumper den ausgekoppelten Laserpuls verbreitern kann.

Gemäß einer Ausführungsform weist die erste und/oder die zweite Leitung einen Widerstand auf, wobei insbesondere in die erste Leitung und/oder die zweite Leitung ein Widerstand bzw. ein Widerstands-Bauelement eingebunden ist. Ein derartiger Widerstand kann eingesetzt werden, um etwaig auftretende unerwünschte Schwingungen zu dämpfen. Es kann dabei vorgesehen sein, dass der Widerstand zwischen die Induktivität und dem jeweiligen Anschluss der Pockelszelle gekoppelt ist. Es kann jedoch ebenso vorgesehen sein, dass die Induktivität zwischen den Widerstand und dem jeweiligen Knotenpunkt der Schalteinheiten gekoppelt ist.

Gemäß einer Ausführungsform der Treiberschaltung liegt der Induktivitätswert je nach Länge des zu formenden Spannungspulses von einigen wenigen (bspw. Faktor 1-10) Nanosekunden bis zu einigen (bspw. Faktor 1-10) hundert Nanosekunden von einer oder beiden der Induktivitäten in einem Bereich von ca. 1 µH bis einigen (bspw. Faktor 1-10) 10 mH.

Gemäß einer Ausführungsform der Treiberschaltung weist die Induktivität eine einfache Zylinderspule auf.

Gemäß einer Ausführungsform der Treiberschaltung ist der Induktivitätswert der Induktivität oder, falls vorhanden, beider Induktivitäten einstellbar. Zu diesem Zweck kann die Induktivität beispielsweise Ferrite aufweisen, welche in Sättigung betrieben werden. Dadurch kann erreicht werden, dass die Krümmung der Spannungs-/Zeit-Kurve noch stärker als bei einer normalen Induktivität ausfällt, insbesondere dann, wenn der Ferrit die Sättigung erreicht.

Gemäß einer Ausführungsform der Treiberschaltung liegt der Widerstandswert der in die erste oder zweite Leitung eingefügten Widerstände je nach Länge des zu formenden Spannungspulses und je nach Bemessung der Induktivität in einem Bereich von ca. 100 Ohm bis einige 10 kOhm.

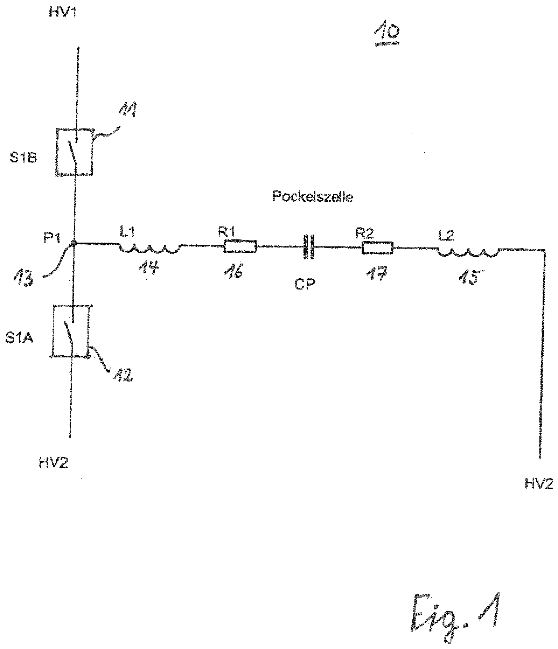

Gemäß einer Ausführungsform der Treiberschaltung ist diese als Push-Pull-Schaltung ausgebildet und enthält zu diesem Zweck einen mit der ersten Leitung verbundenen Schaltungsknoten, welcher durch eine dritte Leitung über eine erste Schalteinheit mit einem ersten Potential zu verbinden ist, und welcher durch eine vierte Leitung über eine zweite Schalteinheit mit einem zweiten Potential zu verbinden ist, wobei die zweite Leitung mit einem dritten Potential zu verbinden ist. Das zweite Potential und das dritte Potential können einander gleich sein. Eine derartige Push-Pull-Schaltung wird weiter unten mit Bezug auf Fig. 1 näher beschrieben.

Gemäß einer Ausführungsform der Treiberschaltung ist diese als eine Brückenschaltung ausgebildet und enthält zu diesem Zweck einen mit der ersten Leitung verbundenen ersten Schaltungsknoten, welcher durch eine dritte Leitung über eine erste Schalteinheit mit einem ersten Potential zu verbinden ist, und welcher durch eine vierte Leitung über eine zweite Schalteinheit mit einem zweiten Potential zu verbinden ist, und ferner einen zweiten Schaltungsknoten, welcher durch die zweite Leitung mit dem zweiten Anschluss der Pockelszelle zu verbinden ist, und welcher durch eine fünfte Leitung über eine dritte Schalteinheit mit einem dritten Potential zu verbinden ist, und welcher durch eine sechste Leitung über eine vierte Schalteinheit mit einem vierten Potential zu verbinden ist.

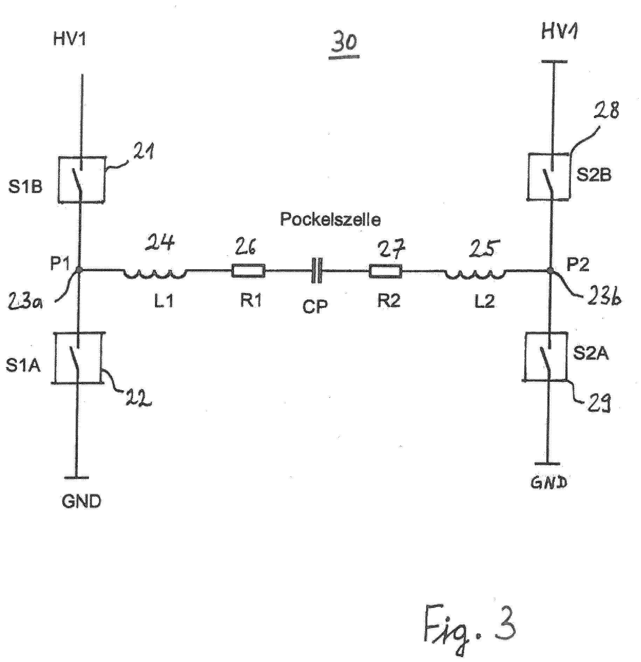

Gemäß einer Ausführungsform einer derartigen Brückenschaltung sind das erste Potential und das dritte Potential einander gleich, insbesondere gegeben durch das positive Potential einer Spannungsquelle, und das zweite Potential und das vierte Potential einander gleich, insbesondere gegeben durch ein Massepotential. Ein derartiger Schaltmodus einer Brückenschaltung wird auch als dpp-Modus bezeichnet und weiter unten mit Bezug auf Fig. 3 näher beschrieben.

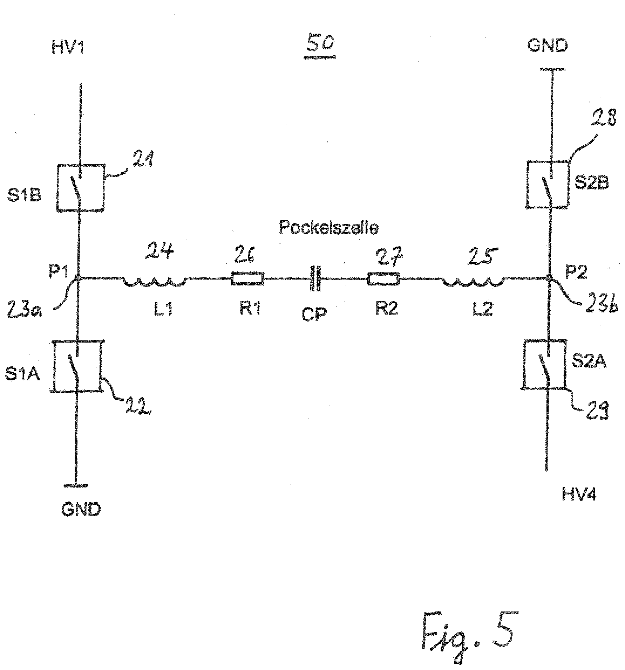

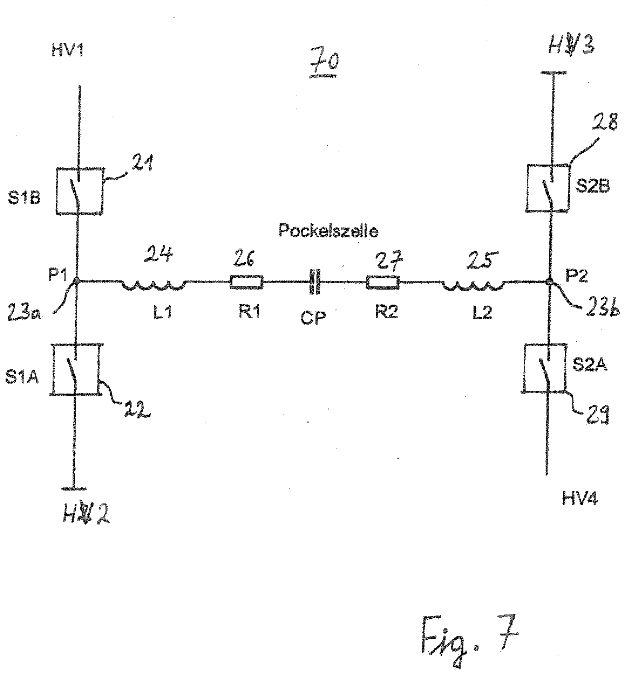

Gemäß einer Ausführungsform der Brückenschaltung ist das erste Potential positiver als das zweite Potential und das dritte Potential positiver als das vierte Potential, wobei die Differenz zwischen dem ersten Potential und dem vierten Potential größer ist als die Differenz zwischen dem ersten Potential und dem zweiten Potential, und wobei die Differenz zwischen dem ersten Potential und dem vierten Potential größer ist als die Differenz zwischen dem dritten Potential und dem vierten Potential. Gemäß einer weiteren Ausführungsform hiervon wird das erste Potential durch den Pluspol einer Spannungsquelle bereitgestellt und das vierte Potential durch den Minuspol der Spannungsquelle bereitgestellt. Gemäß einer weiteren Ausführungsform sind das zweite Potential und das dritte Potential einander gleich und können insbesondere durch ein Massepotential gegeben sein. Gemäß einer alternativen Ausführungsform können das zweite Potential und das dritte Potential voneinander verschieden sein. Diese beiden denkbaren Ausführungsformen einer Brückenschaltung werden auch als bpp-Modus bezeichnet und werden weiter unten mit Bezug auf die Figuren 5 und 7 näher beschrieben.

In der Fig. 1 ist eine Ausführungsform einer Treiberschaltung in Form einer Push-Pull-Schaltung schematisch dargestellt. Die Push-Pull-Schaltung 10 weist eine erste Schalteinheit 11 und eine zweite Schalteinheit 12 auf. Die Schalteinheiten 11 und 12 sind in Reihe zwischen ein erstes elektrisches Potential HV1 und ein zweites elektrisches Potential HV2 geschaltet, wobei das erste Potential HV1 durch den Pluspol einer Spannungsquelle bereitgestellt sein kann und das zweite Potential HV2 durch den Minuspol der Spannungsquelle bereit gestellt sein kann. Das zweite Potential HV2 kann auch durch einen Masseanschluß GND gegeben sein.

Die beiden Schalteinheiten 11 und 12 können bezüglich ihres inneren Aufbaus durch einen einfachen Transistor oder eine Transistorkette gegeben sein.

Die erste Schalteinheit 11 ist mit ihrem ersten Anschluss mit dem ersten elektrischen Potential HV1 und mit ihrem zweiten Anschluss mit einem Schaltungsknoten 13 verbunden. Die zweite Schalteinheit 12 ist mit ihrem ersten Anschluss mit dem Schaltungsknoten 13 und mit ihrem zweiten Anschluss mit dem zweiten elektrischen Potential HV2 verbunden. Der Schaltungsknoten 13 ist wiederum mit einem ersten Anschluss einer ersten Induktivität 14 (L1) verbunden. Ein zweiter Anschluss der Induktivität 14 ist mit einem ersten Anschluss eines ersten Widerstands 16 (R1) verbunden. Der zweite Anschluss des Widerstands 15 ist mit einem ersten Anschluss einer Pockelszelle CP verbunden. Der zweite Anschluss der Pockelszelle ist mit einem ersten Anschluss eines zweiten Widerstands 17 (R2) verbunden. Der zweite Anschluss des Widerstands 17 ist mit einem ersten Anschluss einer zweiten Induktivität 15 (L2) verbunden. Der zweite Anschluss der zweiten Induktivität 15 ist mit dem zweiten elektrischen Potential HV2 verbunden. Die Widerstände 16 und 17 sind lediglich optional und können auch weggelassen werden. Sie können dazu dienen, etwaig auftretende unerwünschte Schwingungen zu dämpfen. Es kann auch vorgesehen sein, dass nur einer beiden Widerstände 16 und 17 vorhanden ist.

Die Push-Pull-Schaltung 10 wird so betrieben, dass stets eine der beiden Schalteinheiten 11 und 12 geschlossen ist, während die jeweils andere der beiden Schalteinheiten 11 und 12 geöffnet ist. Wenn die Schalteinheit 12 geschlossen und die Schalteinheit 11 geöffnet ist, so ist die Pockelszelle CP spannungslos. Im umgekehrten Fall liegt nach einer durch L1, L2, R1, R2 und der Kapazität der Pockelszelle CP bestimmten Zeit bzw. Zeit-Spannungskurve die gesamte Hochspannung an der Pockelszelle CP an. Wird dann wieder die Schalteinheit 12 geschlossen und die Schalteinheit 11 geöffnet, so ist nach einer durch L1, L2, R1, R2 und der Kapazität der Pockelszelle CP bestimmten Zeit bzw. Zeit-Spannungskurve die Pockelszelle CP wieder spannungslos. Im einfachsten Fall kann jede der beiden Schalteinheiten 11 und 12 durch einen einfachen Transistor oder durch eine Transistorkette gegeben sein. In diesem Fall stellt jede der Schalteinheiten 11 und 12 unverzögerte Schaltflanken bereit, da jeder Transistor so schnell schalten kann, wie es seinem Aufbau und seinen Fähigkeiten entspricht.

Die Schalteinheiten 11 und 12 können im wesentlichen aus einer Transistorkette aus N MOS-Feldeffekttransistoren (MOSFETs) bestehen, die bezüglich ihrer Source-/Drain-Strecken in Serie geschaltet sind. Die MOSFETs können durch bekannte Lade-/Entlade-Schaltungen an- bzw. abgeschaltet werden, die jeweils mit dem Gate- und dem Source-Anschluss der MOSFETs verbunden sind. Eine solche Anordnung ist als ein Hochspannungsschalter ausgebildet. Hochspannungsschalter können Spannungen bis zu einigen Kilovolt oder einigen 10 Kilovolt schalten. Die Schaltzeiten von derartigen Hochspannungsschaltern liegen im Bereich weniger Nanosekunden und lassen sich beispielsweise durch TTL-Signale mit einem Signalpegel von wenigen Volt ansteuern. Der innere Aufbau dieser Hochspannungsschalter, insbesondere der Lade-/ Entlade-Schaltungen CLN, ist beispielsweise in der DE 3630775 C2 beschrieben und braucht somit vorliegend nicht näher erörtert zu werden.

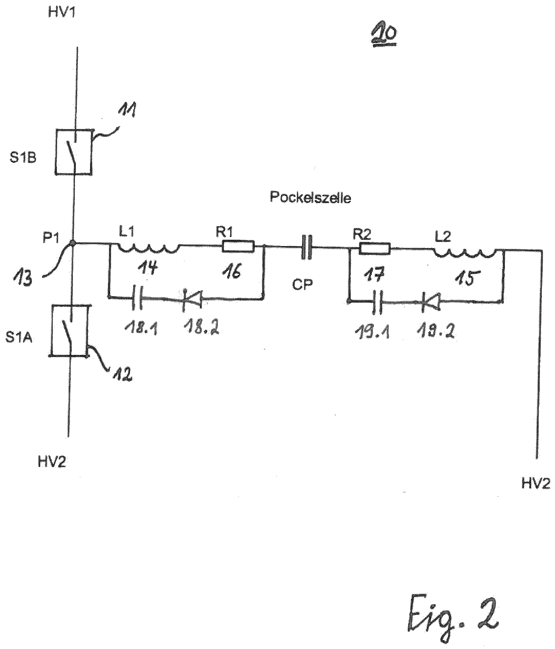

In der Fig. 2 ist eine Ausführungsform einer Treiberschaltung in Form einer Push-Pull-Schaltung schematisch dargestellt. Die Ausführungsform 20 der Fig. 2 unterscheidet sich von der Ausführungsform der Fig. 1 lediglich dadurch, dass ein erster Kondensator 18.1 und/oder eine erste Diode 18.2 der Serienschaltung aus der ersten Induktivität 14 und dem ersten Widerstand 16 parallel geschaltet ist und ein zweiter Kondensator 19.1 und/oder eine zweite Diode 19.2 der Serienschaltung aus der zweiten Induktivität 15 und dem zweiten Widerstand 17 parallel geschaltet ist. Gemäß der Zeichnung werden sowohl die Kondensatoren als auch die Dioden eingesetzt, wobei es jedoch ausreichend sein kann, nur jeweils eine von beiden zu verwenden. Es kann auch vorgesehen sein, dass die beiden Leitungen unterschiedlich beschaltet werden, dass also beispielsweise in der ersten Leitung ein Kondensator und in der zweiten Leitung eine Diode (oder umgekehrt) eingesetzt werden. Die Dioden 18.2, 19.2 sind in Sperr-Richtung gezeichnet, wobei sich dies auf den Zeitpunkt des Anschaltens t0 bezieht. Wie oben bereits ausgeführt, kann auch vorgesehen sein, die Dioden zum Zeitpunkt t0 in Durchlass-Richtung zu polen.

Die Kapazitätswerte der Kondensatoren 18.1, 19.1 und/oder der Dioden 18.2, 19.2 sind dabei insbesondere sehr niedrig, insbesondere unterhalb von 100 pF. Es kann auch vorgesehen sein, dass nur einer der beiden Kondensatoren 18.1, 19.1 und/oder Dioden 18.2, 19.2 vorhanden sind. Die Kondensatoren 18.1, 19.1 und/oder Dioden 18.2, 19.2 dienen dazu, einen Teil der schnellen Schaltflanke der Schalteinheiten 11 und 12 auf die Pockelszelle CP zu übertragen. Sie haben auch Einfluß auf die Kurvenform des langsamen Spannungsanstiegs. Die Dioden 18.2, 19.2 dienen insbesondere der schnellen Entladung der Pockelszelle CP zum Zeitpunkt t1.

In der Fig. 3 ist eine Treiberschaltung in Form einer Brückenschaltung gemäß einer Ausführungsform schematisch dargestellt. Die Brückenschaltung 30 besteht im Wesentlichen aus einer sogenannten H-Konfiguration. Diese H-Konfiguration weist zwei Schaltungsknoten 23a (P1) und 23b (P2) auf, die an die elektrischen Anschlüsse einer Pockelszelle (CP) anzuschließen sind. Der erste Schaltungsknoten 23a ist durch eine erste Leitung über eine erste Induktivität 24 (L1) und einen ersten Widerstand 26 (R1) mit einem ersten Anschluss der Pokkelszelle CP verbunden. Der zweite Schaltungsknoten 23b ist durch eine zweite Leitung über eine zweite Induktivität 25 (L2) und einen zweiten Widerstand 27 (R2) mit dem zweiten Anschluss der Pockelszelle CP verbunden. Die Schaltungsknoten 23a und 23b sind im Übrigen Ausgangspunkt von vier weiteren Leitungen, die den vier Schenkeln des Buchstabens H entsprechen. Der erste Schaltungsknoten 23a ist durch eine dritte Leitung über eine erste Schalteinheit 21 (S1B) mit einem ersten elektrischen Potential HV1 und durch eine vierte Leitung über eine zweite Schalteinheit 22 (S1A) mit einem zweiten elektrischen Potential wie einem Masseanschluss GND verbunden, während der zweite Schaltungsknoten 23b durch eine fünfte Leitung über eine dritte Schalteinheit 28 (S2B) mit dem ersten elektrischen Potential HV1 und durch eine sechste Leitung über eine vierte Schalteinheit 29 (S2A) mit dem zweiten elektrischen Potential wie dem Masseanschluss GND verbunden.

Für die Schalteinheiten 21, 22, 28 und 29 gilt dasselbe wie für die Schalteinheiten der zuvor beschriebenen Push-Pull-Schaltungen der Figuren 1 und 2.

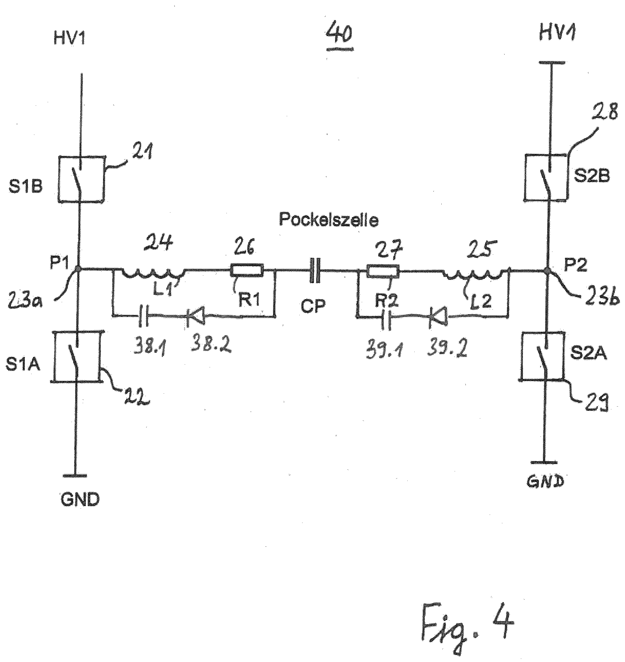

In der Fig. 4 ist eine Ausführungsform einer Treiberschaltung in Form einer Brückenschaltung schematisch dargestellt. Die Ausführungsform 40 der Fig. 4 unterscheidet sich von der Ausführungsform der Fig. 3 lediglich dadurch, dass ein erster Kondensator 38.1 und/oder eine erste Diode 38.2 der Serienschaltung aus der ersten Induktivität 24 und dem ersten Widerstand 26 parallel geschaltet ist und ein zweiter Kondensator 39.1 und/oder eine zweite Diode 39.2 der Serienschaltung aus der zweiten Induktivität 25 und dem zweiten Widerstand 27 parallel geschaltet ist. Bezüglich der Kondensatoren 38.1, 39.1 und Dioden 38.2, 39.2 gilt dasselbe wie das weiter oben zu den entsprechenden Bauelementen der Fig. 2 Ausgeführte.

In der Fig. 5 ist eine Treiberschaltung in Form einer Brückenschaltung entsprechend einer weiteren Ausführungsform schematisch dargestellt. Die Brückenschaltung 50 entspricht im Wesentlichen der Brückenschaltung 30 der Fig. 3, unterscheidet sich von dieser jedoch hinsichtlich der zugeführten elektrischen Potentiale. Das erste elektrische Potential HV1 kann beispielsweise durch ein positives elektrisches Potential +HV des Pluspols einer Hochspannungsquelle bereitgestellt werden. Das zweite elektrische Potential ist hier durch ein Massepotential GND gegeben und das dritte elektrische Potential ist ebenfalls durch das Massepotential GND gegeben. Das vierte elektrische Potential HV4 kann schließlich durch ein negatives elektrisches Potential -HV des Minuspols der Spannungsquelle gegeben sein.

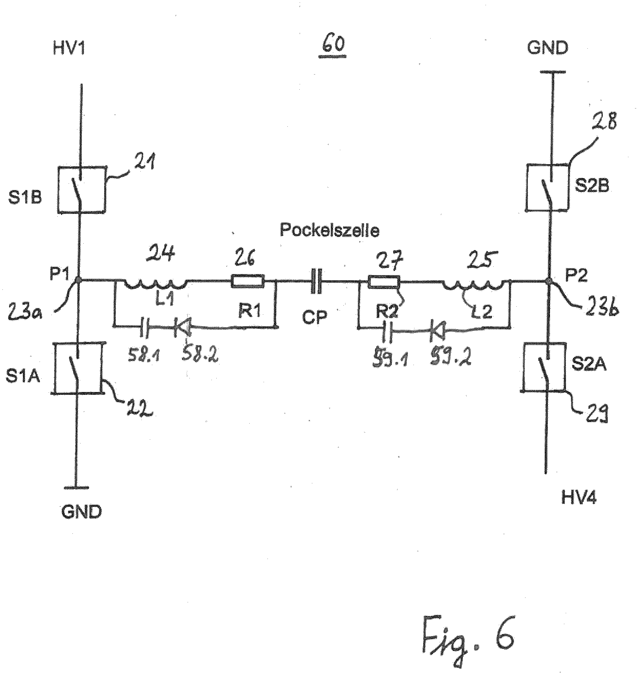

In der Fig. 6 ist eine Ausführungsform einer Treiberschaltung in Form einer Brückenschaltung schematisch dargestellt. Die Ausführungsform 60 der Fig. 6 unterscheidet sich von der Ausführungsform der Fig. 5 lediglich dadurch, dass ein erster Kondensator 58.1 und/oder eine erste Diode 58.2 der Serienschaltung aus der ersten Induktivität 24 und dem ersten Widerstand 26 parallel geschaltet ist und ein zweiter Kondensator 59.1 und/oder eine zweite Diode 59.2 der Serienschaltung aus der zweiten Induktivität 25 und dem zweiten Widerstand 27 parallel geschaltet ist. Bezüglich der Kondensatoren 58.1, 59.1 und Dioden 58.2, 59.2 gilt dasselbe wie das weiter oben zu den entsprechenden Bauelementen der Fig. 2 Ausgeführte.

In der Fig. 7 ist eine Treiberschaltung in Form einer Brückenschaltung gemäß einer weiteren Ausführungsform schematisch dargestellt. In dieser Ausführungsform einer Brückenschaltung 70 sind die elektrischen Potentiale HV1 - HV4 so gewählt, dass die Differenz der Potentiale HV1 - HV4 größer ist als die Differenz der Potentiale HV1 - HV2, und dass die Differenz der Potentiale HV1 - HV4 größer ist als die Differenz der Potentiale HV3 - HV4, und dass - anders als in der Ausführungsform der Fig. 5 - die Potentiale HV2 und HV3 voneinander verschieden sind.

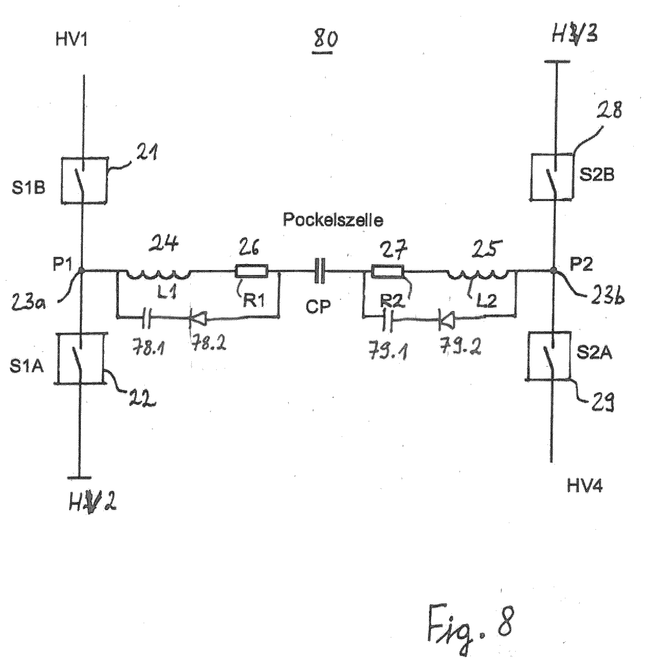

In der Fig. 8 ist eine Ausführungsform einer Treiberschaltung in Form einer Brückenschaltung schematisch dargestellt. Die Ausführungsform 80 der Fig. 8 unterscheidet sich von der Ausführungsform der Fig. 7 lediglich dadurch, dass ein erster Kondensator 78.1 und/oder eine erste Diode 78.2 der Serienschaltung aus der ersten Induktivität 24 und dem ersten Widerstand 26 parallel geschaltet ist und ein zweiter Kondensator 79.1 und/oder eine erste Diode 79.2 der Serienschaltung aus der zweiten Induktivität 25 und dem zweiten Widerstand 27 parallel geschaltet ist. Bezüglich der Kondensatoren 78.1, 79.1 und Dioden 78.2, 79.2 gilt dasselbe wie das weiter oben zu den entsprechenden Bauelementen der Fig. 2 Ausgeführte.

Die vorliegende Anmeldung bezieht sich ebenso auf ein Lasersystem. Ein solches Lasersystem umfaßt eine oder mehrere Pockelszellen, wobei mindestens eine Pockelszelle mit einer in der vorliegenden Anmeldung beschriebenen Treiberschaltung verbunden ist.

Gemäß einer Ausführungsform des erfindungsgemäßen Lasersystems umfaßt dieses ferner eine Laserstrahlquelle und einen oder mehrere optische Verstärker, wobei mindestens eine Pockelszelle im Strahlengang vor einem optischen Verstärker, nach einem optischen Verstärker, oder zwischen zwei optischen Verstärkern angeordnet ist und insbesondere diese Pockelszelle mit einer in der vorliegenden Anmeldung beschriebenen Treiberschaltung verbunden ist. Die Laserstrahlquelle kann beispielsweise eine Dauerstrich-Laserstrahlquelle sein und eine erste Pockelszelle kann im Strahlengang nach der Laserstrahlquelle angeordnet und derart konfiguriert sein, um aus der Dauerstrich-Laserstrahlung Laserpulse zu erzeugen. Die Laserstrahlquelle kann jedoch ebenso eine im Pulsbetrieb mit einer ersten Wiederholrate arbeitende Laserstrahlquelle sein und eine erste Pockelszelle kann im Strahlengang nach der Laserstrahlquelle angeordnet und derart konfiguriert sein, um aus der gepulsten Laserstrahlung eine gepulste Laserstrahlung mit einer zweiten Wiederholrate zu erzeugen, welche niedriger als die erste Wiederholrate ist. Die erste Pockelszelle arbeitet in diesem Fall also im Pulsselektionsmodus (pulse pikking).

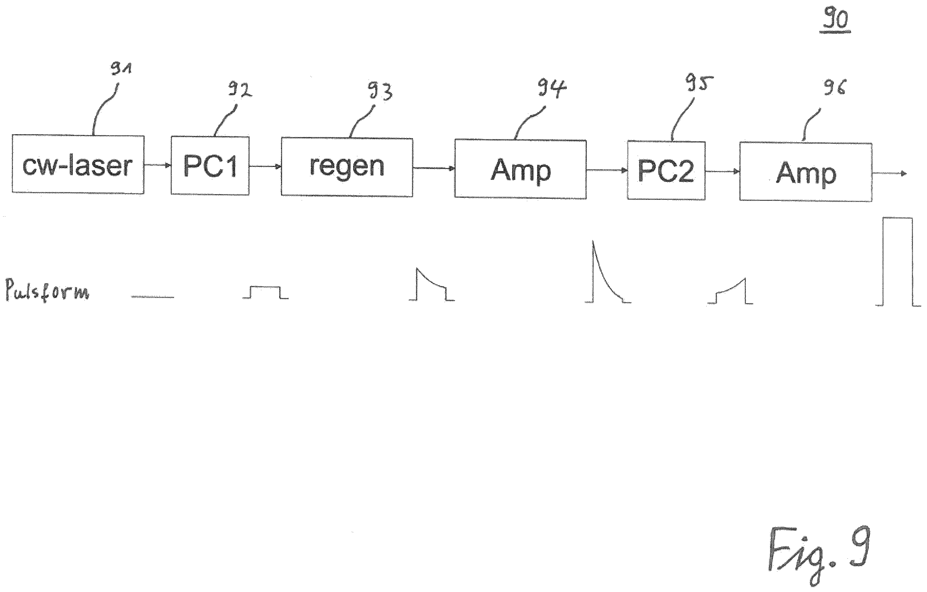

In der Fig. 9 ist eine 3-stufige Verstärkerkette schematisch dargestellt. Unterhalb der als Blöcke dargestellten Einheiten der Verstärkerkette ist symbolhaft die Pulsform der jeweiligen optischen Laserstrahlpulse dargestellt.

Die Verstärkerkette 90 weist an ihrem Anfang eine im Dauerstrich (cw) arbeitende Laserstrahlquelle 91, beispielsweise eine CO₂-Laserstrahlquelle, auf. Die cw-Ausgangsstrahlung der Laserstrahlquelle 91 wird einer ersten Pockelszelle 92 zugeführt, welche zwischen zwei gekreuzten Polarisatoren (nicht dargestellt) angeordnet ist und die cw-Laserstrahlung in eine gepulste Laserstrahlung mit annähernd rechteckförmigen Laserpulsen umwandelt. Die erste Pockelszelle 92 wird zu diesem Zweck mit einer konventionellen Treiberschaltung angesteuert, durch welche übliche An- und Ausschaltzeiten im Nanosekunden-Bereich, also im Bereich 1 ns bis 10 ns, erzielt werden können. Die Pulswiederholrate kann in einem weiten Bereich zwischen 1 KHz und 100 MHz und die Pulslänge kann beispielsweise in einem weiten Bereich von 5 ns bis 1 µs einstellbar sein.

Die von der ersten Pockelszelle 92 erzeugten Laserpulse können sodann einem ersten optischen Verstärker 93 zugeführt werden, welcher als ein sogenannter regenerativer Verstärker ausgebildet sein kann. Dieser stellt eine spezielle Bauform eines optischen Verstärkers dar, welcher einen Resonator und ein innerhalb des Resonators angeordnetes Verstärkungsmedium aufweist, in welchem eine Besetzungsinversion erzeugt wird. Der in den regenerativen Verstärker 93 eingekoppelte Laserpuls läuft mehrfach durch den Resonator und räumt bei jedem Durchlauf einen Teil der Besetzungsinversion ab und wird dabei verstärkt. Sobald die durch die Besetzungsinversion im Verstärkungsmedium gespeicherte Energie hinreichend abgebaut ist, findet keine Verstärkung mehr statt und der Laserpuls wird wieder aus dem Resonator ausgekoppelt. In dem regenerativen Verstärker 93 können typischerweise Verstärkungsfaktoren im Bereich von 10⁴ bis zu 10⁶ erreicht werden.

Die im unteren Teil der Fig. 9 schematisch gezeigte Pulsform des aus dem regenerativen Verstärker 93 austretenden Laserpulses deutet bereits die weiter oben angedeutete Problematik der Gain Depletion an. Der zuvor rechteckförmige Laserpuls wird durch die Gain Depletion derart verformt, dass zwischen den schnellen an- und absteigenden Pulsflanken ein exponentiell abfallender Abschnitt der Strahlungsintensität entsteht, welchen es im weiteren Verlauf zu kompensieren gilt.

Nach Austritt aus dem regenerativen Verstärker 93 treten die Laserpulse in einen weiteren optischen Verstärker 94 ein. Dieser optische Verstärker 94 weist ebenfalls ein Verstärkungsmedium auf, welches durch eine geeignete optische oder elektrische Anregung in einen Zustand einer Besetzungsinversion versetzt wird. Im übrigen jedoch ist der optische Verstärker 94 von einer derartigen Bauform, dass ein zu verstärkender Laserpuls durch einen einmaligen Durchlauf durch das Verstärkungsmedium verstärkt wird. Beim Durchtritt des Laserpulses durch den optischen Verstärker 94 tritt ebenfalls Gain Depletion auf. Wie anhand der Pulsform des aus dem optischen Verstärker 94 austretenden Laserpulses im unteren Teil der Fig. 9 gezeigt ist, verformt sich dadurch der Laserpuls noch stärker in Richtung eines starken Anstiegs der Strahlungsintensität und eines fast ebenso starken exponentiellen Abfalls der Strahlungsintensität über die gesamte Pulsdauer. Der optische Verstärker 94 kann so ausgelegt sein, dass ein Verstärkungsfaktor von 10⁹ erreichbar ist.

Die Aufgabe besteht nun darin, diese Verformung des Laserpulses in der dritten und letzten Verstärkungsstufe rückgängig zu machen. Zu diesem Zweck wird der Laserpuls einer zweiten Pockelszelle 95 zugeführt, welche zwischen zwei gekreuzten Polarisatoren angeordnet ist und welche nun mittels einer Treiberschaltung so angesteuert werden kann, wie es weiter oben beschrieben worden ist. Die Ansteuerung der Pockelszelle 95 und der Durchtritt des Laserpulses durch die so angesteuerte Pockelszelle 95 bewirkt eine Verformung des Laserpulses derart, dass dieser eine schnelle Anstiegsflanke im Nanosekunden-Bereich, einen exponentiell ansteigenden mittleren Abschnitt und eine schnell abfallende Flanke im Nanosekunden-Bereich aufweist.

Der so verformte Laserpuls wird nun einem dritten optischen Verstärker 96 zugeführt. Dieser kann im Prinzip auf gleiche oder ähnliche Weise aufgebaut sein wie der zweite optische Verstärker 94, so dass auch in diesem eine Gain Depletion für einen durchtretenden Laserpuls auftritt. Da dieser nun aber wie vorstehend beschrieben verformt wurde, so dass er im Anfangsbereich keine hohe Strahlungsintensität aufweist, kann die Verstärkung auch nicht so schnell abgebaut werden. Als Resultat erhält man einen Laserpuls, welcher wie im unteren Teil der Fig. 9 gezeigt nach Durchtritt durch den optischen Verstärker 96 ein im Idealfall rechteckförmiges Profil aufweist, jedenfalls ein solches mit im Nanosekunden-Bereich an- und absteigenden Flanken und einem zwischen diesen liegenden Abschnitt mit im Wesentlichen konstanter Strahlungsintensität. Der optische Verstärker 96 kann so ausgelegt sein, dass ein Verstärkungsfaktor von 10⁹ erreichbar ist.

Gemäß einer Ausführungsform eines Lasersystems weist dieses eine Laserstrahlquelle mit einem Laserresonator auf, welcher eine resonatorinterne Pockelszelle enthält. Die Pokkelszelle wird derart von einer in dieser Anmeldung beschriebenen Treiberschaltung angesteuert, dass sie als ein Cavity Dumper wirkt.

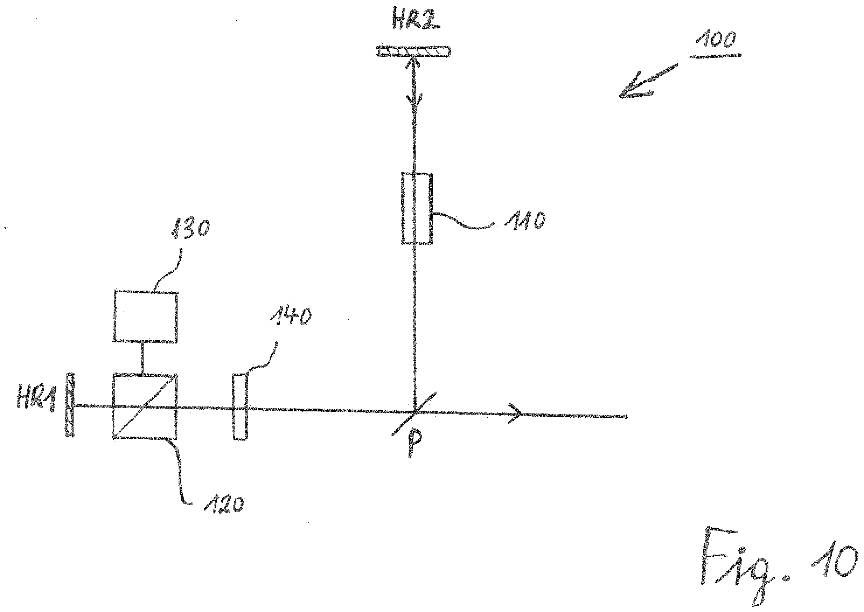

In der Fig. 10 ist eine Ausführungsform einer Laserstrahlquelle mit Cavity Dumper schematisch dargestellt. Die Laserstrahlquelle 100 weist einen cw-Resonator auf, der zwischen den hochreflektierenden Spiegeln HR1 und HR2 angeordnet ist. Innerhalb des Resonators befindet sich ein Verstärkungsmedium 110. Eine Pockelszelle 120 ist innerhalb des Resonators im Lichtweg zwischen einem polarisationsabhängigen Spiegel und dem ersten hochreflektierenden Endspiegel HR1 angeordnet. Vor der Pockelszelle 120 ist ein Lambda/4-Plättchen 140 angeordnet. Der polarisationsabhängige Spiegel P reflektiert beispielsweise s-polarisiertes Licht vollständig, während er für p-polarisiertes Licht vollständig durchlässig ist. Die Pockelszelle 120 ist mit einer in dieser Anmeldung beschriebenen Treiberschaltung 130 wie etwa einer Push-Pull-Schaltung oder einer Brückenschaltung wie weiter oben beschrieben verbunden.

Zwischen zwei Ausgangspulsen ist die Pockelszelle 120 spannungslos und somit optisch inaktiv, so dass die vom Verstärkungsmedium 110 kommende, beispielsweise s-polarisierte Laserstrahlung an dem Spiegel P reflektiert wird und nach zweifachem Durchgang durch die Pockelszelle 120, Lambda/4-Plättchen 140 und Reflexion an dem HR1 nun p-polarisiert ist, und von dem Spiegel P ausgekoppelt wird. Somit findet keine Verstärkung statt, wenn keine Spannung an der Pockelszelle 120 anliegt. Für die Pulserzeugung wird eine Spannung derart an die Pockelszelle 120 angelegt, dass diese bei zweifachem Durchgang eine Drehung der Polarisation um 90° bewirkt, welcher sich zusammen mit der Polarisationsdrehung durch das Lambda/4-Plättchen 140 auf 0° oder 180° addiert. In diesem Zustand ist der Resonator geschlossen, und es findet Verstärkung im Verstärkungsmedium 110 statt. Wenn nun der Pockelszelle 120 langsam die Spannung weggenommen wird, wirkt die Pockelszelle 120 somit zusammen mit dem Spiegel P als eine zeitabhängige Auskopplung. Die mit der Pockelszelle 120 verbundene Treiberschaltung 130 kann so ausgestaltet sein, dass mindestens eine der beiden Schaltflanken des Spannungspulses verlängert wird, so dass der aus dem Resonator ausgekoppelte Laserpuls eine gewünschte zeitliche Länge und eine entsprechend reduzierte Spitzenintensität erhält. Insbesondere kann die Treiberschaltung 130 in einer oder beiden Leitungen eine Diode enthalten. Die Diode kann so gepolt werden, dass zum Zeitpunkt t0 des Anschaltens der Spannung die Diode in Durchlassrichtung gepolt ist und der volle Spannungssprung auf die Pockelszelle CP übertragen wird, und dass zum Zeitpunkt t1 des Ausschaltens der Spannung die Diode in Sperr-Richtung gepolt ist, wodurch zunächst nur ein Teil des Spannungssprungs auf die Pockelszelle CP übertragen wird, und dann die Pokkelszelle langsam entladen wird, so dass entsprechend der Wirkungsweise des Cavity Dumpers der ausgekoppelte Laserpuls verbreitert wird.

Während die Erfindung bezüglich einer oder mehrerer Implementierungen dargestellt und beschrieben worden ist, können an den dargestellten Beispielen Abänderungen und/oder Modifikationen vorgenommen werden, ohne von dem Gedanken und Schutzbereich der beigefügten Ansprüche abzuweichen. Insbesondere sollen bezüglich der durch die oben beschriebenen Komponenten oder Strukturen durchgeführten verschiedenen Funktionen die zum Beschreiben solcher Komponenten beschriebenen Ausdrücke, sofern nicht etwas anderes angegeben ist, einer beliebigen Komponente oder Struktur entsprechen, die die spezifizierte Funktion der beschriebenen Komponente durchführt (die z.B. funktional äquivalent ist), wenngleich sie nicht strukturell der offenbarten Struktur äquivalent ist, die die Funktion in den hierin dargestellten beispielhaften Implementierungen der Erfindung durchführt.

## Patentansprüche

1. Treiberschaltung für Pockelszelle, mit
einer ersten Leitung, welche mit einem ersten Anschluß der Pockelszelle zu verbinden ist, und
einer zweiten Leitung, welche mit einem zweiten Anschluß der Pockelszelle zu verbinden ist, wobei
eine oder beide der ersten Leitung und der zweiten Leitung eine Induktivität (L1, L2) aufweist, insbesondere in die erste Leitung und/oder die zweite Leitung eine Induktivität (L1, L2) bzw. ein Induktivitäts-Bauelement (L1, L2) eingebunden ist,
**dadurch gekennzeichnet, daß**
eine oder beide der ersten Leitung und der zweiten Leitung eine zu der Induktivität (L1, L2) parallel geschaltete Diode aufweist.

2. Treiberschaltung nach Anspruch 1, bei welcher eine oder beide der ersten Leitung und der zweiten Leitung einen zu der Induktivität parallel geschalteten und mit der Diode in Reihe geschalteten Kondensator oder Kondensator-Bauelement aufweist.

3. Treiberschaltung nach den Ansprüche 1 oder 2, bei welcher die Induktivitätswerte des oder der Induktivitäten (L1, L2) und/oder die Kapazitätswerte des oder der Kondensatoren so bemessen sind, dass durch die Treiberschaltung ein Spannungspuls erzeugbar ist, welcher eine Anstiegsflanke im Nanosekunden-Bereich, einen sich daran anschließenden exponentiell ansteigenden Abschnitt, und eine sich daran anschließende abfallende Flanke im Nanosekunden-Bereich aufweist.

4. Treiberschaltung nach einem der vorhergehenden Ansprüche, bei welcher
eine oder beide der ersten Leitung und der zweiten Leitung einen mit der Induktivität in Reihe geschalteten Widerstand oder Widerstands-Bauelement (R1, R2) aufweist.

5. Treiberschaltung nach einem der vorhergehenden Ansprüche, bei welcher
der Induktivitätswert von einer oder beiden der Induktivitäten (L1, L2) in einem Bereich 1 *µ*H bis 100 mH liegt.

6. Treiberschaltung nach Anspruch 2, bei welcher der Kapazitätswert des oder der Kondensatoren in einem Bereich von ≤ 0,1 nF liegt.

7. Treiberschaltung nach einem der vorhergehenden Ansprüche, bei welcher
der Induktivitätswert von einer oder beiden der Induktivitäten (L1, L2) einstellbar ist.

8. Treiberschaltung nach einem der vorhergehenden Ansprüche, ferner mit
einem mit der ersten Leitung verbundenen Schaltungsknoten (P1), welcher durch eine dritte Leitung über eine erste Schalteinheit (S1B) mit einem ersten Potential (HV1) zu verbinden ist, und welcher durch eine vierte Leitung über eine zweite Schalteinheit (S1A) mit einem zweiten Potential (HV2) zu verbinden ist, wobei die zweite Leitung mit einem dritten Potential (HV2) zu verbinden ist.

9. Treiberschaltung nach einem der vorhergehenden Ansprüche, ferner mit
einem mit der ersten Leitung verbundenen ersten Schaltungsknoten (P1), welcher durch eine dritte Leitung über eine erste Schalteinheit (S1B) mit einem ersten Potential (HV1) zu verbinden ist, und welcher durch eine vierte Leitung über eine zweite Schalteinheit (S1A) mit einem zweiten Potential (HV2) zu verbinden ist, und mit
einem zweiten Schaltungsknoten (P2), welcher durch die zweite Leitung mit dem zweiten Anschluß der Pockelszelle zu verbinden ist, und welcher
durch eine fünfte Leitung über eine dritte Schalteinheit (S2B) mit einem dritten Potential (H1 ; GND; HV3) zu verbinden ist, und welcher
durch eine sechste Leitung über eine vierte Schalteinheit (S2A) mit einem vierten Potential (GND; HV4) zu verbinden ist.

10. Pockelszelle mit einer Treiberschaltung nach einem der vorhergehenden Ansprüche.

11. Lasersystem, umfassend
mindestens eine Pockelszelle mit einer Treiberschaltung nach einem der vorhergehenden Ansprüche 1 bis 9.

12. Lasersystem nach Anspruch 11, ferner umfassend eine Laserstrahlquelle;
einen oder mehrere optische Verstärker, wobei mindestens eine Pockelszelle im Strahlengang vor einem optischen Verstärker angeordnet ist.

13. Lasersystem nach Anspruch 12, bei welchem die Laserstrahlquelle eine Dauerstrich-Laserstrahlquelle ist, und
eine erste Pockelszelle im Strahlengang nach der Laserstrahlquelle angeordnet und konfiguriert ist, um aus der Dauerstrich-Laserstrahlung Laserpulse zu erzeugen.

14. Lasersystem nach Anspruch 12, bei welchem die Laserstrahlquelle eine im Pulsbetrieb mit einer ersten Wiederholrate arbeitende Laserstrahlquelle ist, und
eine erste Pockelszelle im Strahlengang nach der Laserstrahlquelle angeordnet und konfiguriert ist, um aus der gepulsten Laserstrahlung eine gepulste Laserstrahlung mit einer zweiten Wiederholrate zu erzeugen, welche niedriger als die erste Wiederholrate ist.

15. Lasersystem nach einem der Ansprüche 13 oder 14, bei welchem im Strahlengang nach der ersten Pockelszelle ein optischer Verstärker in Form eines regenerativen Verstärkers angeordnet ist.

16. Lasersystem nach einem der Ansprüche 12 bis 15, aufweisen mindestens eine Pockelszelle mit einer Treiberschaltung, welche so konfiguriert ist, dass durch sie ein Spannungspuls erzeugbar ist, welcher eine Anstiegsflanke im Nanosekunden-Bereich, einen sich daran anschließenden exponentiell ansteigenden Abschnitt, und eine sich daran anschließende abfallende Flanke im Nanosekunden-Bereich aufweist.

17. Lasersystem nach einem der Ansprüche 11 bis 16, ferner umfassend
eine Laserstrahlquelle mit einem Laserresonator, welcher eine Pockelszelle mit einer Treiberschaltung aufweist, welche so konfiguriert ist, dass die Pockelszelle als ein Cavity Dumper wirkt.

## Claims

1. Driver circuit for Pockels cell, comprising a first line which is to be connected with a first terminal of the Pockels cell, and
a second line which is to be connected with a second terminal of the Pockels cell, wherein
one or both of the first line and the second line comprise an inductivity (L1, L2), in particular an inductivity (L1, L2) or an inductivity device (L1, L2) is integrated in the first line and/or the second line,
**characterized in that**
one or both of the first line and the second line comprise a diode connected in parallel to the inductivity (L1, L2).

2. Driver circuit according to claim 1, in which one or both of the first line and the second line comprise a capacitor or a capacitor device connected in parallel to the inductivity and connected in series with the diode.

3. Driver circuit according to claim 1 or 2, in which the inductivity values of the inductivity or inductivities (L1, L2) and/or the capacitance values of the capacitor or capacitors are calculated such that, by means of the driver circuit, a voltage pulse is generable which comprises a rising edge in a nanosecond range, a subsequent exponentially rising section, and a subsequent trailing edge in a nanosecond range.

4. Driver circuit according to anyone of the preceding claims, in which
one or both of the first line and the second line comprise a resistor or a resistor device (R1, R2) connected in series with the inductivity.

5. Driver circuit according to anyone of the preceding claims, in which
the inductivity value of one or both of the inductivities (L1, L2) lies in a range 1 µH to 100 mH.

6. Driver circuit according to claim 2, in which the capacitance value of the capacitor or the capacitors lies in a range of ≤ 0.1 nF.

7. Driver circuit according to anyone of the preceding claims, in which
the inductivity value of one or both of the inductivities (L1, L2) is adjustable.

8. Driver circuit according to anyone of the preceding claims, further comprising
a circuit node (P1) connected with the first line, which circuit node is to be connected by a third line via a first switch unit (S1B) with a first potential (HV1), and which circuit node is to be connected by a fourth line via a second switch unit (S1A) with a second potential (HV2), wherein the second line is to be connected with a third potential (HV2).

9. Driver circuit according to anyone of the preceding claims, further comprising
a first circuit node (P1) connected with the first line, which first circuit node is to be connected by a third line via a first switch unit (S1B) with a first potential (HV1), and which circuit node is to be connected by a fourth line via a second switch unit (S1A) with a second potential (HV2), and
a second circuit node (P2), which is to be connected by the second line with the second terminal of the Pockels cell, and which second circuit node
is to be connected by a fifth line via a third switch unit (S2B) with a third potential (HV1; GND; HV3), and which second circuit node
is to be connected with a fourth potential (GND; HV4) via a fourth switch unit (S2A).

10. Pockels cell with a driver circuit according to anyone of the preceding claims.

11. Laser system, comprising
at least one Pockels cell with a driver circuit according to anyone of the preceding claims 1 to 9.

12. Laser system according to claim 11, further comprising a laser beam source;
one or more optical amplifiers, wherein at least one Pockels cell is arranged in the beam path in front of an optical amplifier.

13. Laser system according to claim 12, in which the laser beam source is a continuous wave laser beam source, and
the first Pockels cell is arranged in the beam path after the laser beam source and is configured to generate laser pulses out of the continuous wave laser radiation.

14. Laser system according to claim 12, in which the laser beam source is a laser beam source working in a pulsed operation with a first repetition rate, and
a first Pockels cell is arranged in the beam path after the laser beam source and is configured to generate out of the pulsed laser radiation a pulsed laser radiation with a second repetition rate which is lower than the first repetition rate.

15. Laser system according to anyone of claims 13 or 14, in which
in the beam path after the first Pockels cell an optical amplifier in the form of a regenerative amplifier is arranged.

16. Laser system according to anyone of claims 12 to 15, comprising
at least one Pockels cell with a driver circuit which is configured so that by it a voltage pulse is generable which comprises a rising edge in a nanosecond range, a subsequent exponentially rising section, and a subsequent trailing edge in a nanosecond range.

17. Laser system according to anyone of claims 11 to 16, further comprising
a laser beam source with a laser resonator which comprises a Pockels cell with a driver circuit which is configured so that the Pockels cell functions as a cavity dumper.

## Revendications

1. Circuit d'excitation pour cellule de Pockels, avec
un premier conducteur, lequel est à raccorder à une première connexion de la cellule de Pockels, et
un deuxième conducteur, lequel est à raccorder à une deuxième connexion de la cellule de Pockels,
un ou les deux du premier conducteur et du deuxième conducteur comportant une inductivité (L1, L2), une inductivité (L1, L2) ou un composant d'inductivité (L1, L2) étant en particulier intégré dans le premier conducteur et/ou le deuxième conducteur,
**caractérisé en ce**
**qu'**un ou les deux des premier conducteur et deuxième conducteur comporte(nt) une diode connectée parallèlement à l'inductivité (L1, L2).

2. Circuit d'excitation selon la revendication 1, pour lequel un ou les deux des premier conducteur et deuxième conducteur comporte(nt) un condensateur ou un composant à condensateur connecté parallèlement à l'inductivité et connecté en série à la diode.

3. Circuit d'excitation selon les revendications 1 ou 2, pour lequel les valeurs d'inductivité de l'inductivité ou des inductivités (L1, L2) et/ou les valeurs de capacité du ou des condensateurs sont mesurées de telle manière qu'une impulsion de tension peut être produite par le circuit d'excitation, laquelle comporte un flanc ascendant dans une plage de nanosecondes, une section à ascendance exponentielle s'y raccordant et un flanc descendant s'y raccordant dans une plage en nanosecondes.

4. Circuit d'excitation selon l'une quelconque des revendications précédentes, pour lequel un ou les deux des premier conducteur et deuxième conducteur comporte(nt) une résistance ou composant de résistance (R1, R2) connecté en série à l'inductivité.

5. Circuit d'excitation selon l'une quelconque des revendications précédentes, pour lequel la valeur d'inductivité d'une ou des deux inductivités (L1, L2) se situe dans une plage de 1 µH à 100 mH.

6. Circuit d'excitation selon la revendication 2, pour lequel la valeur de capacité du ou des condensateurs se situe dans une plage de ≤ 0,1 nF.

7. Circuit d'excitation selon l'une quelconque des revendications précédentes, pour lequel la valeur d'inductivité d'une ou des deux inductivités (L1, L2) peut être réglée.

8. Circuit d'excitation selon l'une quelconque des revendications précédentes, en outre avec
un noeud de circuits (P1) relié au premier conducteur, lequel est à raccorder par le biais d'une première unité de connexion (S1B) par un troisième conducteur à un premier potential (HV1) et lequel est à raccorder par le biais d'une deuxième unité de connexion (S1A) par un quatrième conducteur à un deuxième potentiel (HV2), le deuxième conducteur étant à relier à un troisième potentiel (HV2).

9. Circuit d'excitation selon l'une quelconque des revendications précédentes, en outre avec un premier noeud de circuits (P1) relié au premier conducteur, lequel est à raccorder par le biais d'une première unité de connexion (S1B) par un troisième conducteur à un premier potentiel (HV1) et lequel est à raccorder par le biais d'une deuxième unité de connexion (S1A) par un quatrième conducteur à un deuxième potentiel (HV2), et avec
un deuxième noeud de circuits (P2), lequel est à raccorder par le deuxième conducteur à la deuxième connexion de la cellule de Pockels, et lequel
est à raccorder par un cinquième conducteur par le biais d'une troisième unité de connexion (S2B) à un troisième potentiel (H1 ; GND ; HV3), et lequel
est à raccorder par un sixième conducteur par le biais d'une quatrième unité de connexion (S2A) à un quatrième potentiel (GND ; HV4).

10. Cellule de Pockels avec un circuit d'excitation selon l'une quelconque des revendications précédentes.

11. Système à laser, comprenant
au moins une cellule de Pockels avec un circuit d'excitation selon l'une quelconque des revendications précédentes 1 à 9.

12. Système à laser selon la revendication 11, comprenant en outre
une source de rayonnement laser ;
un ou plusieurs amplificateurs optiques, au moins une cellule de Pockels étant disposée dans la trajectoire de rayon avant un amplificateur optique.

13. Système à laser selon la revendication 12, pour lequel
la source de rayonnement laser est une source de rayonnement laser à onde continue, et
une première cellule de Pockels est disposée et configurée dans la trajectoire de rayon après la source de rayonnement laser pour produire des impulsions laser à partir du rayonnement laser à onde continue.

14. Système à laser selon la revendication 12, pour lequel
la source de rayonnement laser est une source de rayonnement laser fonctionnant en mode impulsions avec une première vitesse de répétition, et
une première cellule de Pockels est disposée et configurée dans la trajectoire de rayon après la source de rayonnement laser pour produire un rayonnement laser pulsé avec une deuxième vitesse de répétition à partir du rayonnement laser pulsé, laquelle est inférieure à la première vitesse de répétition.

15. Système à laser selon l'une quelconque des revendications 13 ou 14, pour lequel un amplificateur optique sous la forme d'un amplificateur régénérateur est disposé dans la trajectoire de rayon après la première cellule de Pockels.

16. Système à laser selon l'une quelconque des revendications 12 à 15, comportant au moins une cellule de Pockels avec un circuit d'excitation, lequel est configuré de telle sorte qu'une impulsion de tension peut être produite par celui-ci, lequel comporte un flanc ascendant dans une plage de nanosecondes, une section ascendante de façon exponentielle s'y raccordant et un flanc descendant s'y raccordant dans une plage en nanosecondes.

17. Système à laser selon l'une quelconque des revendications 11 à 16, comprenant en outre
une source de rayonnement laser avec un résonateur laser, lequel comporte une cellule de Pockels avec un circuit d'excitation lequel est configuré de telle sorte que la cellule de Pockels agit comme un délesteur de cavité [*Cavity dumper*]*.*
